# EUROPEAN PATENT SPECIFICATION

(11) **EP 3 460 992 B1**
(45) Date of publication and mention of the grant of the patent: **28.06.2023**
(21) Application number: 17192641.3
(22) Date of filing: 22.09.2017
(51) Int. Cl.: H02P 25/22, H03D 13/00, H02M 7/493, H03L 7/08, H02M 3/158

(54) **INVERTER FOR AN ELECTRIC MACHINE, ELECTRIC MACHINE FOR A VEHICLE AND METHOD FOR OPERATING AN INVERTER**
WECHSELRICHTER FÜR EINE ELEKTRISCHE MASCHINE, MASCHINE FÜR EIN FAHRZEUG UND VERFAHREN ZUM BETRIEB EINES WECHSELRICHTERS
ONDULEUR POUR MACHINE ÉLECTRIQUE, MACHINE ÉLECTRIQUE POUR UN VÉHICULE ET PROCÉDÉ DE FONCTIONNEMENT D'UN ONDULEUR

(43) Date of publication of application: 27.03.2019
(73) Proprietor: Valeo eAutomotive Germany GmbH, 91056 Erlangen (DE)
(72) Inventor: Demuth, Thomas, 09212 Limbach-Oberfrohna (DE); Muhamad Ikhwan, Bin Ismail, 91056 Erlangen (DE); Ebersberger, Sebastian, 91052 Erlangen (DE)
(74) Representative: Valeo Powertrain Systems

(56) References cited:
- EP-A1- 2 594 424
- US-A- 5 933 339
- US-A1- 2007 262 823
- US-A1- 2010 072 928
- US-A1- 2011 074 326
- US-A1- 2012 155 139
- US-A1- 2014 062 433

## Description

The present invention relates to an inverter for an electric machine. Aside, the present invention relates to an electric machine for a vehicle and a method for operating an inverter.

Document EP 2 594 424 A1 discloses a controller of a vehicle, the controller including: a power supply; a plurality of motors; a plurality of inverters performing electric power conversion between the power supply and the motors; a detector that determines whether an insulating resistor is defective; a determination unit that determines whether the detector currently performs the determination process; and a control unit that controls operating frequencies of the inverters in accordance with a result provided by the determination unit. When the determination process is currently not performed, the control unit performs random control to arbitrarily vary each of the operating frequencies of the plurality of inverters, and when the determination process is currently performed, the control unit performs limitative control to prohibit the random control to fix the operating frequencies to predetermined values.

Document US 5 933 339 A discloses a static power converter comprising at least one isolated DC power source and an array of power converter modules connected in a multi-level, multi-phase, multi-circuit configuration. Therein, each phase comprises a plurality of circuits and each circuit comprises a parallel configuration of multi-level phase drivers; and each multi-level phase driver comprises a plurality of H-bridges connected in series. The converter further comprises control means for controlling the power semiconductors which interleaves gate signals applied to the H-bridges of the array of multi-level phase drivers. The interleaving being arranged according to an algorithm whereby normal and complementary triangle carrier waveforms of a desired switching frequency are established for each level of a multi-level phase driver, and are phase shifted with respect to each other by an angle αₗᵥₗ =360°/l, where l is the number of levels of the multi-level phase driver and whereby normal and complementary triangle carrier waveforms of the desired switching frequency are established for the multi-level phase drivers of the multiple circuits such that the carrier waveform for each circuit of a level of interest is phase-shifted with respect to the corresponding circuits of the same level by the angle α_{ckt} =αₗᵥₗ /2k where k is the number of static power converter circuits.

Document US 2010/072928 A1 discloses an electrical system for use in a vehicle, the electrical system comprising: an energy source; a motor having a first set of windings and a second set of windings, the first set of windings being electrically isolated from the second set of windings; an inverter module coupled between the energy source and the motor: the inverter module comprising: a first set of phase legs coupled to the first set of windings; and a second set of phase legs coupled to the second set of windings; and a controller coupled to the inverter module, the controller being configured to achieve a desired power flow between the energy source and the motor by: modulating the first set of phase legs using a first carrier signal; and modulating the second set of phase legs using a second carrier signal, the second carrier signal being phase-shifted relative to the first carrier signal.

Document US 2011/074326 A1 discloses a method for operating an electrical drive system comprising a plurality of drive units, each of the plurality of drive units comprising an inverter bridge comprising pairs of inverter switches. The method comprises the steps of: obtaining a plurality of triangular carrier signals, each of the plurality of triangular carrier signals associated with a different one of the plurality of drive units and having an electrical degree phase shift in relation to each other of the plurality of triangular carrier signals; obtaining a plurality of modulation signals, each of the plurality of modulation signals associated with a one of the pairs of inverter switches in each of the plurality of drive units and having an electrical degree phase shift in relation to each other of the plurality of modulation signals; and generating control signals for each one of the plurality of drive units based on comparison of the plurality of modulation signals to a one of the plurality of triangular carrier signals associated with the one of the plurality of drive units.

Document US 2014/062433 A1 discloses a system comprising: a multi-phase switching converter that receives an input voltage and that supplies an output voltage to a load via a plurality of phases, wherein each phase comprises:
a plurality of switches; an on-time generator module that determines an on-time of the switches; a switch control module that controls a switching frequency of the switches based on the on-time and a clock signal; and an inductance that connects the switches to the load; and a converter control module that varies the switching frequency without varying the on-time or varies the on-time without varying the switching frequency when current through the load varies.

Document US 2012/155139 A1 discloses an electrical energy conversion circuit device for converting a direct input voltage into a direct output voltage, the electrical energy conversion circuit device comprising: a positive contact and a common contact of constant potential for receiving the direct input voltage, a first buck-boost converter connected to the positive contact and the common contact and adapted to generate a first intermediate current in dependence of a first control signal, a second buck-boost converter connected in parallel to the first buck-boost converter and adapted to generate a second intermediate current in dependence of a second control signal, an output capacitor adapted to receive the first and the second intermediate current and to generate the direct output voltage in dependence of the first and the second intermediate current, a controller adapted to provide the first control signal and the second control signal such that the first and the second intermediate current are phase shifted to each other, thereby regulating the direct output voltage in magnitude.

Document US 2007/262823 A1 discloses a synchronized multiphase oscillator.

Inverters are widely used to convert a DC voltage into a multiphase AC output which supplies stator windings of an electric machine. With respect to automotive applications, particularly battery electric vehicles (BEV) and hybrid electric vehicles, the DC voltage is typically obtained from a high voltage battery and the multiphase AC output is provided to an electric machine for driving the electric vehicle. To generate high torque by the electric machine the inverter has to provide high AC currents. It has already been proposed to use a power unit, wherein each switching element comprises two or more semiconductor switches connected in parallel and controlled commonly by a control unit. However, this solution suffers from high effort for designing such a power unit individually for each application.

Furthermore, it has been proposed to provide at least two power units each configured to provide a multiphase AC output to the electric machine, wherein the power units are connected in parallel. Typically, the control unit provides a set of interleaved pulse sequences to each power unit. With respect to simple pulse sequences, the control unit is able to compensate asymmetric currents between the power units. Advantageously, such an interleaved pulsing of the power units reduces ripples in a DC-link of the inverter. The paper by Bhattacharya, Subhadeep et. al "Interleaved SVPWM and DPWM for Dual Three-Phase Inverter-PMSM: An Automotive Application" (in: 2014 IEEE Transportation Electrification Conference and Expo (ITEC), Dearborn, MI, 2014, pp. 1-6) discloses such an inverter. However, a realization of more complex control schemes, particularly with a variable PWM frequency of the sets of pulse sequences, has not been proposed.

Thus, it is an object of the present invention to provide a possibility to realize more complex control schemes for an inverter, particularly suitable to match the high automotive requirements concerning costs and mounting space.

This object is solved by an inverter according to claim 1, an electric machine according to claim 3 and a method for operating an inverter according to claim 4.

The invention is based upon the consideration to combine the techniques of an interleaved parallel inverter and an inverter with variable modulation frequency by enabling the control unit to actively adjust the mutual phase position of each set of pulse sequences. Advantageously, this allows the use of complex control schemes like synchronous modulation or pulse frequency wobbling while operating the inverter with two or more power units connected in parallel. This allows to benefit from the advantages of these control schemes when high torques, particularly for automotive applications, are required. With respect to costs and mounting space the inverter allows a scalable design by using an appropriate number of, preferably similar or equal, power units controlled by one control unit.

Typically, each power unit provides a three-phase AC output. Thus, the inverter may provide a number of output phases corresponding to the product of the number of power units and the number of output phases of each power unit. The electric machine may comprise a number of stator windings corresponding to the number of output phases of the inverter. Preferably, the power units are structurally identical and/or configured to be operated separately. The power units may be integral units and/or configured to be removably mountable to the inverter. Typically, each power unit comprises a plurality of switching elements, e.g. semiconductor switching elements such as insulated gate bipolar transistors, insulated gate field-effect transistors or junction field-effect transistors. The switching elements of each power unit may be connected to half bridges corresponding to the number of output phases of the power unit. Each switching element may comprise a control terminal, such as a gate terminal, controllable by the control unit to switch according to one pulse sequence. The main unit may be configured to compute and/or to specify the values of the variable frequency over time. The term "set of pulse sequences" refers to the pulse sequences provided to the switching elements of one power unit. One set of pulse sequences may comprise a number of pulse sequences corresponding to the number of switching elements of one power unit. With respect to the present invention the term "interleaved" means a temporal offset between respective sets of pulse sequences.

The modulation unit may have a number of input ports corresponding to the number of interleaved frequencies to be modulated. The number of interleaved frequencies may be equal to the number of power units.

By providing the modulation unit and the feedforward unit of the inverter according to the invention, the variation of the pulsing frequency is achieved by varying the basic frequency. Consequently, the first power unit may be controlled by the modulated basic signal and the at least one other power unit may be controlled by the modulated adjusted basic signal. With other words, the basic signal of the first power unit is used as reference for the other power units. The first power unit may thus be considered as a master power unit and the other power units as slave power units.

Particularly, the feedforward unit may adapt to the frequency of the basic signal by performing at least one intermediate period. The adjusted basic signal may thus lag the basic signal.

Besides, the modulation unit may be configured to perform a carrier-based pulse width modulation of the triangular basic signal and/or the adjusted triangular basic signal. As an alternative, the modulation unit may be configured to perform a space-vector pulse width modulation of the basic signal and/or the adjusted basic signal. In this case the basic signal may be a certain input quantity processible by the modulation unit.

The adjustment within one period allows a very fast adaption of frequency variation.

Basically, the adjustment of the phase position might be performed by the PLL unit as well. However, due to the settling time of a PLL which may comprise several periods, the feedforward unit is used for frequency adjustment. The PLL unit being assigned to the feedforward unit and the PLL unit and the feedforward unit being connected to correct the phase position of the adjusted basic signal allow a synthesis of the sets of pulse sequences with a highly precise phase progression.

All statements referring to the inventive inverter may apply to the inventive electric machine and the inventive method, so that advantages achieved by the inventive inverter may be achieved by the inventive electric machine and the inventive method as well.

In the following, the invention is described in detail, whereby reference is made to the principal drawings, which show:
- Fig. 1: a block diagram of an embodiment of an inventive electric machine with an inventive inverter; and
- Fig. 2: a diagram depicting a basic signal and an adjusted basic signal over time.

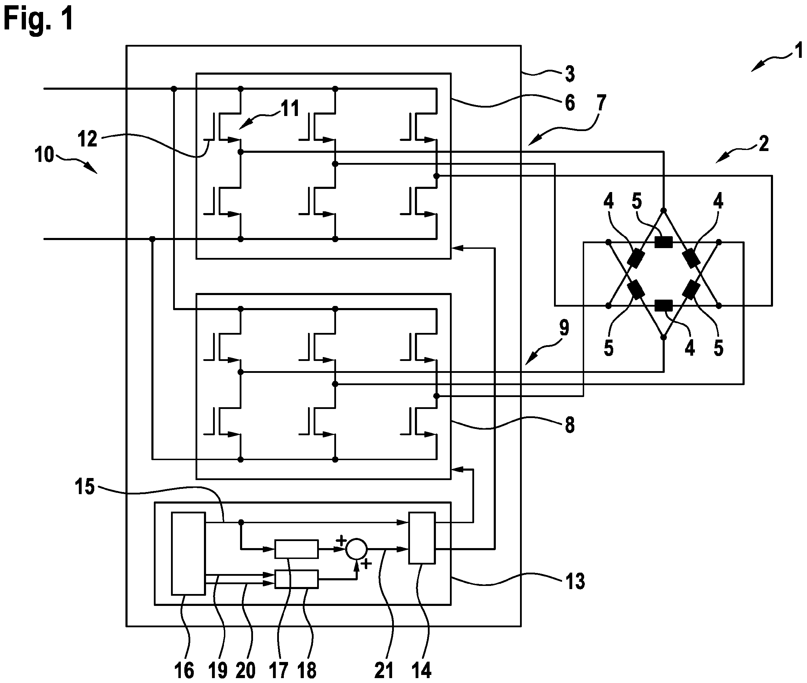

Fig. 1 is a block diagram of an embodiment of an electric machine 1, comprising a stator 2 and an inverter 3. The electric machine 1 is particularly suitable to drive an electric vehicle, such as a battery electric vehicle (BEV) or a hybrid electric vehicle, wherein the inverter 3 is able to provide complex control schemes at high torques with low costs and mounting space.

The stator 2 comprises a first stator winding arrangement with three stator windings 4 and a second stator winding arrangement with three stator windings 5. The stator windings 4, 5 of each stator winding arrangements are delta connected, exemplarily.

The inverter 3 comprises a first power 6 unit with a three-phase AC output 7 connected to the stator windings 4 of the first stator winding arrangement and a second power unit 8 with a three-phase AC output 9 connected to the stator windings 5 of the second stator winding arrangement. The power units 6, 8 are substantially identical, integral units and configured to be removably mountable to the inverter 3. The power units 6, 8 are connected in parallel to a DC-link 10 of the inverter 3.

Each power unit 6, 8 comprises a plurality of switching elements 11 connected to half bridges. The switching elements 11 are semiconductor switching elements, e.g. insulated gate bipolar transistors, insulated gate field-effect transistors (IGBT), such as metal-oxide-semiconductor field-effect transistors (MOSFET), or junction field-effect transistors (JFET). Each switching element 11 comprises a control terminal 12, such as a gate terminal, by which the switching element 11 may be switched to its conducting and blocking switching state. Additionally, each power unit 6, 8 comprises a plurality of driver units (not depicted) each connected in series to the control terminal 12 of a respective switching element 11.

Aside, the inverter 3 comprises a control unit 13 configured to provide a set of pulse sequences to each power unit 6, 8. The pulse sequences are fed to a respective control terminal 12 via the driver unit for amplifying the pulse sequence such that the switching elements 11 provide the AC current to the AC outputs 7, 9. In Fig. 1 wirings between the control unit 13 and the switching elements 11 are not depicted for reasons of simplicity. The phase positions of the sets of pulse sequences are interleaved to each other according to their arrangement of the stator windings 4, 5.

The control unit 13 comprises a modulation unit 14 configured to perform a carrier-based pulse width modulation (PWM) and to provide the sets of pulse sequences. The set of pulse sequences to the first power unit 6 results from a modulation of a basic signal 15 provided by a main unit 16 of the controller 13. The basic signal 15 is a triangular signal representing the actual frequency of the pulse width modulated pulse sequences. Accordingly, the main unit 16 is configured to vary frequency of the basic signal with respect to an implemented control strategy, such as synchronous modulation or wobbling of the pulsing frequency.

Additionally, the basic signal 15 is fed into a feedforward unit 17 of the controller 13. The feedforward unit has a finite impulse response and is configured to adjust the phase position of the basic signal 15 to the interleaved phase position of the set of pulse sequences for the second power unit 8. To stabilize the adjusted basic signal obtained from the feedforward unit 17 the controller comprises a PLL unit 18 configured to correct the phase position depending on the actual phase position 19 and a predefined phase setpoint 20 obtained from the main unit 16. The modulation unit 14 obtains the adjusted and corrected basic signal 21 and modulates it. Thus, the first power unit 6 may be considered as a reference or a master unit for the second power unit 8 working as a slave unit.

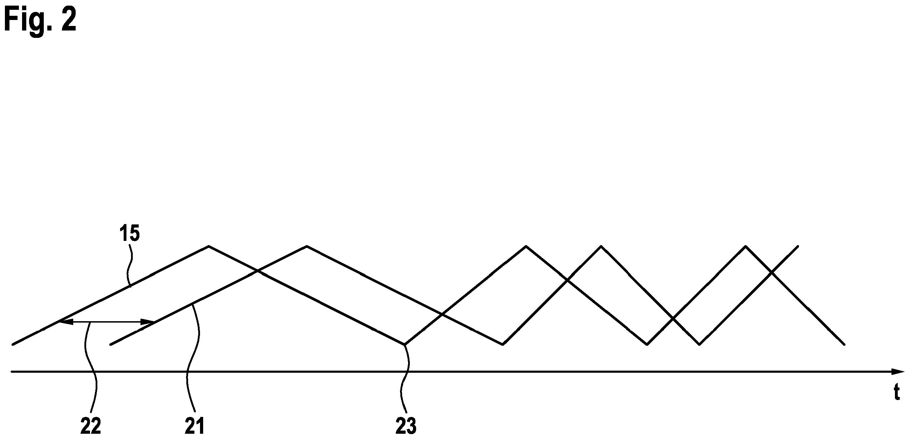

Fig. 2 is a diagram depicting the basic signal 15 and the adjusted and corrected basic signal 21 over time t. As can be seen both signals have a mutual phase offset 22 resulting in sets of pulse sequences with a mutual phase position of 90°. At the time 23 the main unit 16 varies the frequency of the basic signal 15. This variation is detected by the feedforward unit 18 which adjusts the basic signal 15 to remain the phase position 22 within an intermediate period. Then, the adjusted basic signal is corrected by the PLL unit 18 resulting in the signal 23 which is modulated and used to control the second power unit 8, whereas the modulated basic signal 15 is used to control the first power unit 6.

According to another embodiment of an inverter corresponding to the above-mentioned one, more than two power units are provided to supply a corresponding number of stator arrangements of the stator 2. Such a configuration corresponds to the embodiment of Fig. 1 in that additional second power units 8 and additional branches of feedforward units 17 and PLL units 18 are provided. Thus, the first power unit 6 works as master unit and the multiple second power units 8 work as slave units.

According to another embodiment of an inverter corresponding to any of the above-mentioned ones, the modulation unit 14 is configured to perform space-vector pulse width modulation of the basic signal, which is generally not a triangular function but a suitable input parameter for the modulation unit 14 and a correspondingly modified feedforward unit 18 and PLL unit 20.

## Claims

1. Inverter (3) for an electric machine (1), comprising a first power unit (6) and a second power unit (8) being parallelly connected and each configured to provide a multiphase AC output (7, 9) to stator windings (4, 5) of the electric machine (1) and a control unit (13) configured to provide a set of pulse sequences to each power unit (6, 8), phase positions of the sets of pulse sequences being interleaved to each other, the control unit (13) being further configured to vary a pulsing frequency of the sets of pulse sequences and to adjust the mutual phase position of each set of pulse sequences to the interleaved phase positions when varying the pulsing frequency;
the control unit (13) comprising
- a feedforward unit (17) for the second power unit (8),
- a modulation unit (14) configured to provide the sets of pulse sequences by pulse width modulation, to modulate a basic signal (15) and to provide the set of pulse sequences obtained by modulating the basic signal (15) to the first power unit (6),
- a PLL unit (18) assigned to the feedforward unit (17) and
- a main unit (16) configured to provide the basic signal (15) to the feedforward unit (17), to vary a frequency of the basic signal (15) with respect to an implemented control strategy and to provide an actual phase position (19) and a predefined phase setpoint (20) to the PLL unit (18); wherein
the feedforward unit (17) has a finite impulse response and is configured to adjust a phase position of the basic signal (15) to the interleaved phase position of the set of pulse sequences for the second power unit (8) within one period after varying the frequency; wherein
the PLL unit (18) is configured to correct the phase position depending on the actual phase position (19) and the predefined phase setpoint (20), the PLL unit (18) and the feedforward unit (17) being connected to correct the phase position of the basic signal adjusted by the feedforward unit (17) and to provide an adjusted and corrected basic signal (21), the basic signal (15) and the adjusted and corrected basic signal (21) having a mutual phase offset (22); wherein
the modulation unit (14) is further configured to obtain the adjusted and corrected basic signal (21), to modulate it and to provide the set of pulse sequences to the second power unit (8).

2. Inverter (3) according to claim 1, **characterized in that** the modulation unit (14) is configured to perform a carrier-based pulse width modulation of the triangular basic signal (15) or a space-vector pulse width modulation of the basic signal (15).

3. Electric machine (1) for a vehicle, comprising an inverter (3) according to claim 1 or 2 and a plurality of stator winding arrangements each configured to be supplied by one power unit (6, 8).

4. Method for operating an inverter (3) for an electric machine (1), comprising a first power unit (6) and a second power unit (8) being parallelly connected and each providing a multiphase AC output (7, 9) to stator windings (4, 5) of the electric machine (1), wherein a set of pulse sequences is provided to each power unit (6, 8), phase positions of the sets of pulse sequences being interleaved to each other, wherein, by a control unit (13) of the inverter (3), a pulsing frequency of the sets of pulse sequences is varied and the mutual phase position of each set of pulse sequences is adjusted after varying the pulsing frequency;
the control unit (13) comprising:
- a feedforward unit (17) for the second power unit (8), the feedforward unit (17) having a finite impulse response,
- a modulation unit (14) configured to provide the sets of pulse sequences by pulse width modulation,
- a PLL unit (18) assigned to the feedforward unit (17) and
- a main unit (16);
the method comprising:
- providing, by the main unit (16), a basic signal (15) to the modulation unit (14);
- modulating, by the modulation unit (14), the basic signal (15);
- providing, by the modulation unit (14), the set of pulse sequences obtained by modulating the basic signal (15) to the first power unit (6),
- varying, by the main unit (16), a frequency of the basic signal (15) with respect to an implemented control strategy,
- providing, by the main unit (16), an actual phase position (19) and a predefined phase setpoint (20) to the PLL unit (18),
- adjusting, by the feedforward unit (17), a phase position of the basic signal (15) to the interleaved phase position of the set of pulse sequences for the second power unit (8) within one period after varying the frequency,
- correcting, by the PLL unit (18), the phase position depending on the actual phase position (19) and the predefined phase setpoint (20), the PLL unit (18) and the feedforward unit (17) being connected to correct the phase position of the basic signal adjusted by the feedforward unit (17) and to provide an adjusted and corrected basic signal (21), the basic signal (15) and the adjusted and corrected basic signal (21) having a mutual phase offset (22),
- obtaining, by the modulation unit (14), the adjusted and corrected basic signal (21),
- modulating, by the modulation unit (14), the adjusted and corrected basic signal (21), and
- providing, by the modulation unit (14), the set of pulse sequences to the second power unit (8).

## Patentansprüche

1. Wechselrichter (3) für eine elektrische Maschine (1), umfassend eine erste Leistungseinheit (6) und eine zweite Leistungseinheit (8), die parallelgeschaltet und jeweils dazu ausgelegt sind, eine mehrphasige Wechselstromausgabe (7, 9) zu Statorwicklungen (4, 5) der elektrischen Maschine (1) bereitzustellen, und eine Steuereinheit (13), die dazu ausgelegt ist, einen Satz von Impulsfolgen zu jeder Leistungseinheit (6, 8) bereitzustellen, wobei Phasenlagen der Sätze von Impulsfolgen ineinander verschachtelt sind, wobei die Steuereinheit (13) ferner dazu ausgelegt ist, eine Impulsfrequenz der Sätze von Impulsfolgen zu variieren und die gegenseitige Phasenlage jedes Satzes von Impulsfolgen bei Variieren der Impulsfrequenz an die verschachtelten Phasenlagen anzupassen;
wobei die Steuereinheit (13) umfasst
- eine Vorwärtskopplungseinheit (17) für die zweite Leistungseinheit (8),
- eine Modulationseinheit (14), die dazu ausgelegt ist, die Sätze von Impulsfolgen durch Pulsweitenmodulation bereitzustellen, ein Grundsignal (15) zu modulieren und den durch Modulieren des Grundsignals (15) erhaltenen Satz von Impulsfolgen zu der ersten Leistungseinheit (6) bereitzustellen,
- eine PLL-Einheit (18), die der Vorwärtskopplungseinheit (17) zugeordnet ist, und
- eine Haupteinheit (16), die dazu ausgelegt ist, das Grundsignal (15) zu der Vorwärtskopplungseinheit (17) bereitzustellen, eine Frequenz des Grundsignals (15) in Bezug auf eine implementierte Steuerstrategie zu variieren und eine tatsächliche Phasenlage (19) und einen vordefinierten Phasensollwert (20) zu der PLL-Einheit (18) bereitzustellen; wobei
die Vorwärtskopplungseinheit (17) eine finite Impulsantwort aufweist und dazu ausgelegt ist, eine Phasenlage des Grundsignals (15) an die verschachtelte Phasenlage des Satzes von Impulsfolgen für die zweite Leistungseinheit (8) innerhalb einer Periode nach Variieren der Frequenz anzupassen; wobei
die PLL-Einheit (18) dazu ausgelegt ist, die Phasenlage abhängig von der tatsächlichen Phasenlage (19) und dem vordefinierten Phasensollwert (20) zu korrigieren, wobei die PLL-Einheit (18) und die Vorwärtskopplungseinheit (17) verbunden sind, um die durch die Vorwärtskopplungseinheit (17) angepasste Phasenlage des Grundsignals zu korrigieren und ein angepasstes und korrigiertes Grundsignal (21) bereitzustellen, wobei das Grundsignal (15) und das angepasste und korrigierte Grundsignal (21) einen gegenseitigen Phasenversatz (22) aufweisen; wobei
die Modulationseinheit (14) ferner dazu ausgelegt ist, das angepasste und korrigierte Grundsignal (21) zu erhalten, es zu modulieren und den Satz von Impulsfolgen zu der zweiten Leistungseinheit (8) bereitzustellen.

2. Wechselrichter (3) nach Anspruch 1, **dadurch gekennzeichnet, dass** die Modulationseinheit (14) dazu ausgelegt ist, eine trägerbasierte Pulsweitenmodulation des dreieckigen Grundsignals (15) oder eine Raumzeiger-Pulsweitenmodulation des Grundsignals (15) durchzuführen.

3. Elektrische Maschine (1) für ein Fahrzeug, umfassend einen Wechselrichter (3) nach Anspruch 1 oder 2 und eine Mehrzahl von Statorwicklungsanordnungen, die jeweils dazu ausgelegt sind, durch eine Leistungseinheit (6, 8) versorgt zu werden.

4. Verfahren zum Betreiben eines Wechselrichters (3) für eine elektrische Maschine (1), umfassend eine erste Leistungseinheit (6) und eine zweite Leistungseinheit (8), die parallelgeschaltet sind und jeweils eine mehrphasige Wechselstromausgabe (7, 9) zu Statorwicklungen (4, 5) der elektrischen Maschine (1) bereitstellen, wobei ein Satz von Impulsfolgen zu jeder Leistungseinheit (6, 8) bereitgestellt wird, wobei Phasenlagen der Sätze von Impulsfolgen ineinander verschachtelt sind, wobei, durch eine Steuereinheit (13) des Wechselrichters (3), eine Impulsfrequenz der Sätze von Impulsfolgen variiert wird und die gegenseitige Phasenlage jedes Satzes von Impulsfolgen nach Variieren der Impulsfrequenz angepasst wird;
wobei die Steuereinheit (13) umfasst:
- eine Vorwärtskopplungseinheit (17) für die zweite Leistungseinheit (8), wobei die Vorwärtskopplungseinheit (17) eine finite Impulsantwort aufweist,
- eine Modulationseinheit (14), die dazu ausgelegt ist, die Sätze von Impulsfolgen durch Pulsweitenmodulation bereitzustellen,
- eine PLL-Einheit (18), die der Vorwärtskopplungseinheit (17) zugeordnet ist, und
- eine Haupteinheit (16);
wobei das Verfahren umfasst:
- Bereitstellen, durch die Haupteinheit (16), eines Grundsignals (15) zu der Modulationseinheit (14);
- Modulieren, durch die Modulationseinheit (14), des Grundsignals (15);
- Bereitstellen, durch die Modulationseinheit (14), des Satzes von Impulsfolgen, der durch Modulieren des Grundsignals (15) erhalten wird, zu der ersten Leistungseinheit (6),
- Variieren, durch die Haupteinheit (16), einer Frequenz des Grundsignals (15) in Bezug auf eine implementierte Steuerstrategie,
- Bereitstellen, durch die Haupteinheit (16), einer tatsächlichen Phasenlage (19) und eines vordefinierten Phasensollwerts (20) zu der PLL-Einheit (18),
- Anpassen, durch die Vorwärtskopplungseinheit (17), einer Phasenlage des Grundsignals (15) an die verschachtelte Phasenlage des Satzes von Impulsfolgen für die zweite Leistungseinheit (8) innerhalb einer Periode nach Variieren der Frequenz,
- Korrigieren, durch die PLL-Einheit (18), der Phasenlage abhängig von der tatsächlichen Phasenlage (19) und dem vordefinierten Phasensollwert (20), wobei die PLL-Einheit (18) und die Vorwärtskopplungseinheit (17) verbunden sind, um die durch die Vorwärtskopplungseinheit (17) angepasste Phasenlage des Grundsignals zu korrigieren und ein angepasstes und korrigiertes Grundsignal (21) bereitzustellen, wobei das Grundsignal (15) und das angepasste und korrigierte Grundsignal (21) einen gegenseitigen Phasenversatz (22) aufweisen,
- Erhalten, durch die Modulationseinheit (14), des angepassten und korrigierten Grundsignals (21),
- Modulieren, durch die Modulationseinheit (14), des angepassten und korrigierten Grundsignals (21), und
- Bereitstellen, durch die Modulationseinheit (14), des Satzes von Impulsfolgen zu der zweiten Leistungseinheit (8).

## Revendications

1. Onduleur (3) pour une machine électrique (1), comprenant une première unité d'alimentation (6) et une seconde unité d'alimentation (8) étant reliées parallèlement et chacune configurée pour fournir une sortie CA multiphasée (7, 9) à des enroulements de stator (4, 5) de la machine électrique (1) et une unité de commande (13) configurée pour fournir un ensemble de séquences d'impulsions à chaque unité d'alimentation (6, 8), des positions de phase des ensembles de séquences d'impulsions étant entrelacées les unes aux autres, l'unité de commande (13) étant en outre configurée pour faire varier une fréquence d'impulsion des ensembles de séquences d'impulsions et pour ajuster la position de phase mutuelle de chaque ensemble de séquences d'impulsions sur les positions de phase entrelacées lors de la variation de la fréquence d'impulsion ;
l'unité de commande (13) comprenant
- une unité d'anticipation (17) pour la seconde unité d'alimentation (8),
- une unité de modulation (14) configurée pour fournir les ensembles de séquences d'impulsions par modulation de largeur d'impulsion, pour moduler un signal de base (15) et pour fournir l'ensemble de séquences d'impulsions obtenu en modulant le signal de base (15) à la première unité d'alimentation (6),
- une unité PLL (18) attribuée à l'unité d'anticipation (17) et
- une unité principale (16) configurée pour fournir le signal de base (15) à l'unité d'anticipation (17), pour faire varier une fréquence du signal de base (15) par rapport à une stratégie de commande mise en œuvre et pour fournir une position de phase réelle (19) et un point de consigne de phase prédéfini (20) à l'unité PLL (18) ; dans lequel
l'unité d'anticipation (17) a une réponse d'impulsion finie et est configurée pour ajuster une position de phase du signal de base (15) à la position de phase entrelacée de l'ensemble de séquences d'impulsions pour la seconde unité d'alimentation (8) pendant une période après la variation de la fréquence ; dans lequel
l'unité PLL (18) est configurée pour corriger la position de phase en fonction de la position de phase réelle (19) et du point de consigne de phase prédéfini (20), l'unité PLL (18) et l'unité d'anticipation (17) étant reliées pour corriger la position de phase du signal de base ajusté par l'unité d'anticipation (17) et pour fournir un signal de base ajusté et corrigé (21), le signal de base (15) et le signal de base ajusté et corrigé (21) ayant un décalage de phase mutuel (22) ; dans lequel
l'unité de modulation (14) est en outre configurée pour obtenir le signal de base ajusté et corrigé (21), pour le moduler et pour fournir l'ensemble de séquences d'impulsions à la seconde unité d'alimentation (8).

2. Onduleur (3) selon la revendication 1, **caractérisé en ce que** l'unité de modulation (14) est configurée pour réaliser une modulation de largeur d'impulsion basée sur porteuse du signal de base triangulaire (15) ou une modulation de largeur d'impulsion par vecteur spatial du signal de base (15).

3. Machine électrique (1) pour un véhicule, comprenant un onduleur (3) selon la revendication 1 ou 2 et une pluralité d'agencements d'enroulement de stator chacun configuré pour être alimenté par une unité d'alimentation (6, 8).

4. Procédé de fonctionnement d'un onduleur (3) pour une machine électrique (1), comprenant une première unité d'alimentation (6) et une seconde unité d'alimentation (8) étant reliées parallèlement et fournissant chacune une sortie CA multiphasée (7, 9) à des enroulements de stator (4, 5) de la machine électrique (1), dans lequel un ensemble de séquences d'impulsions est fourni à chaque unité d'alimentation (6, 8), des positions de phase des ensembles de séquences d'impulsions étant entrelacées les unes aux autres, dans lequel, par une unité de commande (13) de l'onduleur (3), une fréquence d'impulsion des ensembles de séquences d'impulsions est variée et la position de phase mutuelle de chaque ensemble de séquences d'impulsions est ajustée après la variation de la fréquence d'impulsion ;
l'unité de commande (13) comprenant
- une unité d'anticipation (17) pour la seconde unité d'alimentation (8), l'unité d'anticipation (17) ayant une réponse d'impulsion finie,
- une unité de modulation (14) configurée pour fournir les ensembles de séquences d'impulsions par modulation de largeur d'impulsion,
- une unité PLL (18) attribuée à l'unité d'anticipation (17) et
- une unité principale (16) ;
le procédé comprenant :
- la fourniture, par l'unité principale (16), d'un signal de base (15) à l'unité de modulation (14) ;
- la modulation, par l'unité de modulation (14), du signal de base (15) ;
- la fourniture, par l'unité de modulation (14), de l'ensemble de séquences d'impulsions obtenu en modulant le signal de base (15) à la première unité d'alimentation (6),
- la variation, par l'unité principale (16), d'une fréquence du signal de base (15) par rapport à une stratégie de commande mise en oeuvre,
- la fourniture, par l'unité principale (16), d'une position de phase réelle (19) et d'un point de consigne de phase prédéfini (20) à l'unité PLL (18),
- l'ajustement, par l'unité d'anticipation (17), d'une position de phase du signal de base (15) à la position de phase entrelacée de l'ensemble de séquences d'impulsions pour la seconde unité d'alimentation (8) pendant une période après la variation de la fréquence,
- la correction, par l'unité PLL (18), de la position de phase en fonction de la position de phase réelle (19) et du point de consigne de phase prédéfini (20), l'unité PLL (18) et l'unité d'anticipation (17) étant reliées pour corriger la position de phase du signal de base ajusté par l'unité d'anticipation (17) et pour fournir un signal de base ajusté et corrigé (21), le signal de base (15) et le signal de base ajusté et corrigé (21) ayant un décalage de phase mutuel (22),
- l'obtention, par l'unité de modulation (14), du signal de base ajusté et corrigé (21),
- la modulation, par l'unité de modulation (14), du signal de base ajusté et corrigé (21), et
- la fourniture, par l'unité de modulation (14), de l'ensemble de séquences d'impulsions à la seconde unité d'alimentation (8).
